# EUROPEAN PATENT APPLICATION

(11) **EP 2 650 070 A1**
(43) Date of publication of application: **16.10.2013**
(21) Application number: 12004920.0
(22) Date of filing: 02.07.2012
(51) Int. Cl.: B23D 57/00

(54) **Wire-type cutting device**

(30) Priority: 13.04.2012 JP 2012091749
(71) Applicant: Tokyo Rope Mfg Co., Ltd., Tokyo 103-8306 (JP)
(72) Inventor: Oikawa, Sachio, Tokyo 103-8306 (JP)
(74) Representative: Gleiss, Alf-Olav

(57) **Abstract**

According to an embodiment, a wire-type cutting device (1) is characterized by including, a main roller portion (10) comprising a main roller (11, 12) on which a cutting wire (2) is stretched, and a reel (31) which delivers or takes up the wire (2), the reel (31) and the main roller (11, 12) being disposed having the same axial direction and capable of being arranged so that the wire (2) between the reel (31) and the main roller (11, 12) is substantially perpendicular to the axial direction.

## Description

The present invention relates to a wire-type cutting device.

A wire-type cutting device, also called a wire saw, is designed to cut workpieces by pressing them against a running wire. This cutting device comprises a main roller portion, workpiece feeding device, delivery mechanism, and take-up mechanism. The main roller portion comprises a pair of main rollers (grooved rollers) between which the cutting wire is stretched. The workpiece feeding device moves the workpieces toward the main roller portion. The delivery mechanism feeds the wire to the main roller portion. The take-up mechanism winds up and recovers the wire from the main roller portion. The wire is delivered from a reel of the delivery mechanism, fed to the main roller portion, stretched in the main roller portion, passed from the main roller portion to the take-up mechanism, and taken up by a reel of the take-up mechanism. In general, such a configuration is used that the axes of the take-up and delivery reels extend at right angles to those of the main rollers and the running direction of the wire is changed by guide rollers between the main rollers and reels.

The wire-type cutting device described above has the following problem. In the configuration in which the axes of the reels extend at right angles to those of the main rollers and the running direction of the wire is changed by the guide rollers, the wire is liable to be bent, rotated, or twisted.

A wire-type cutting device according to an aspect of the invention comprises a main roller portion comprising a main roller on which a cutting wire is stretched and a reel which delivers or takes up the wire, and is **characterized in that** the reel and the main roller are disposed having the same axial direction and can be arranged so that positions of the wire at the reel and the main roller are flush with respect to the axial direction.

According to the present invention, there can be provided a wire-type cutting device capable of reducing the possibility of a wire being bent, rotated, or twisted.

According to an embodiment, a wire-type cutting device includes, a main roller portion comprising a main roller on which a cutting wire is stretched, and a reel which delivers or takes up the wire, the reel and the main roller being disposed having the same axial direction and capable of being arranged so that positions of the wire at the reel and the main roller are flush with respect to the axial direction.

The invention can be more fully understood from the following detailed description when taken in conjunction with the accompanying drawings, in which:
FIG. 1 is an external perspective view showing a wire-type cutting device;
FIG. 2 is an explanatory diagram showing layouts of rollers and wire travel routes of the cutting device; and
FIG. 3 is an explanatory diagram showing the wire travel routes of the cutting device.

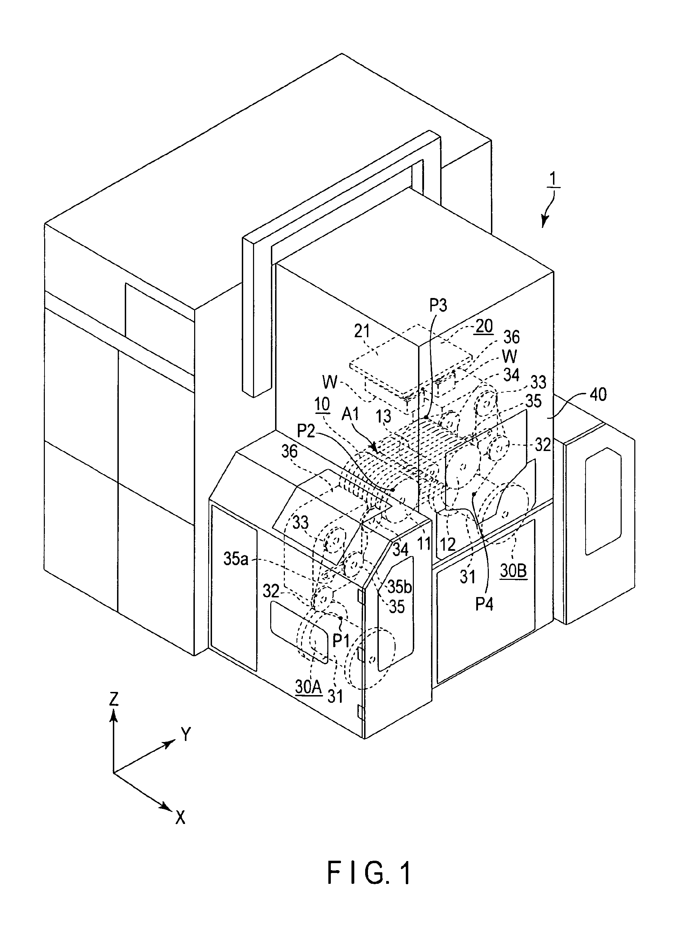

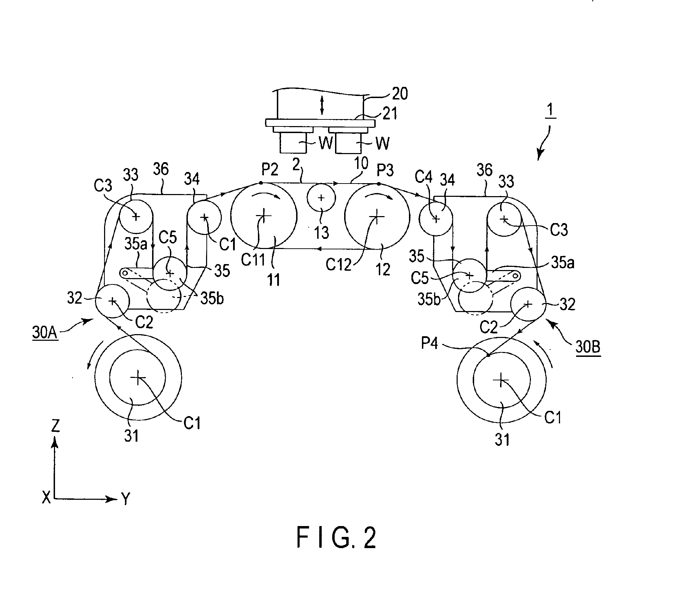

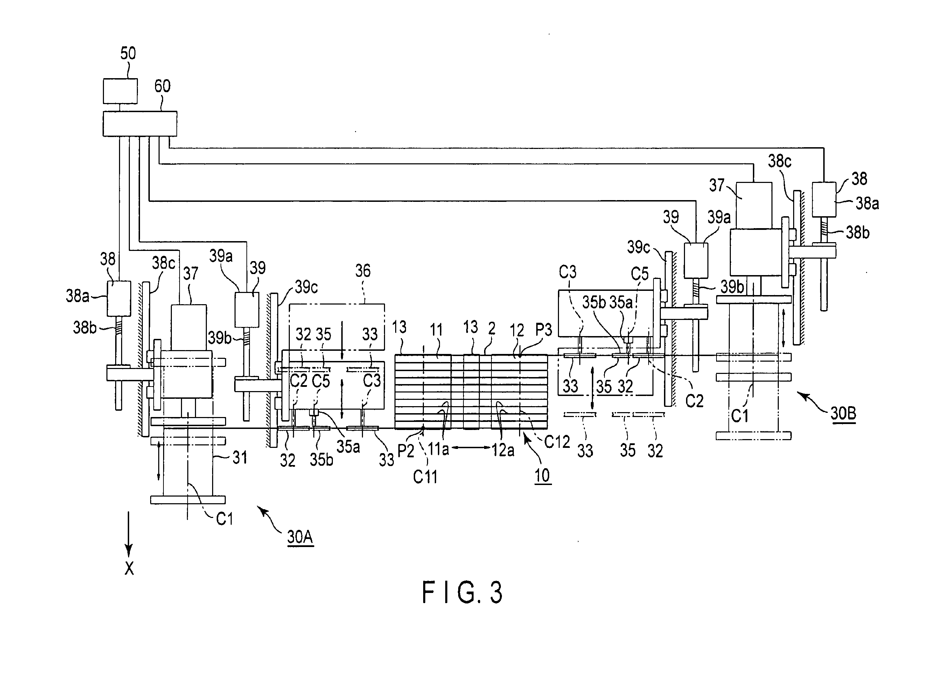

One embodiment of the present invention will now be described with reference to FIGS. 1 to 3. FIG. 1 is an external perspective view schematically showing a wire-type cutting device 1 according to the present invention. FIG. 2 is an explanatory diagram showing layouts of various rollers and wire travel routes of the cutting device 1. FIG. 3 is a partial development view of the internal structure of the cutting device 1 taken along the wire travel routes. This view is developed with respect to grooved rollers 11 and 12. In these drawings, several structural elements are not shown for ease of illustration. Further, arrows X, Y and Z indicate three orthogonal directions. In the present embodiment, for example, arrows X, Y and Z indicate the longitudinal direction (or axial direction), transverse direction, and vertical direction, respectively, of the cutting device.

The wire-type cutting device 1 cuts workpieces (materials to be cut) W by pressing them against a running cutting wire 2. The cutting device 1 is used to cut a brittle material, such as a semiconductor material, magnetic material, ceramic, or printed circuit board, into the shape of a wafer or other shape.

As shown in FIG. 1, the wire-type cutting device 1 comprises a main roller portion 10, workpiece feeding device (material support section) 20, delivery mechanism 30A, take-up mechanism 30B, and casing 40. The main roller portion 10 comprises a pair of grooved rollers (main rollers) 11 and 12 between which the cutting wire 2 is stretched. The workpiece feeding device 20 supports and moves the workpieces W toward or away from the main roller portion 10. The delivery mechanism 30A delivers and feeds the cutting wire 2 to the main roller portion 10. The take-up mechanism 30B winds up and recovers the cutting wire 2 from the main roller portion 10. The casing 40 accommodates all these elements. As shown in FIG. 3, moreover, the cutting device 1 comprises an operation input section 50 and control section 60. An operator uses the operation input section 50 to input instructions and the like. The control section 60 controls the operations of the individual parts according to the input content of the operation input section 50.

As shown in FIG. 1, the main roller portion 10 is located in the front central part of the wire-type cutting device 1. The workpieces W are located above and opposite the main roller portion 10 by the workpiece feeding device 20, and the delivery and take-up mechanisms 30A and 30B are disposed individually on the opposite sides of the main roller portion 10. A machining chamber in which the main roller portion 10 and workpieces W are located opposite one another is covered by an open-close cover.

The main roller portion 10 comprises the pair of grooved rollers 11 and 12 that are arranged on a base in the central part of the cutting device. Grooved rollers 11 and 12 are rotatable cylinders located parallel to each other such that their axes extend in the X-direction. Grooves 11a and 12a are formed on the respective outer peripheral surfaces of grooved rollers 11 and 12 such that they extend circumferentially relative to the rollers. The grooves 11a and 12a are arranged at regular axial intervals. The cutting wire 2 is held in the grooves 11a and 12a as it is wound a plurality of times and tightly stretched. In a predetermined cutting area A1 set according to the shape and size of the workpieces W, the turns of the cutting wire 2 arranged at regular intervals in the X-direction between grooved rollers 11 and 12 extend in parallel rows in the Y-direction. A driving roller may be used for one of grooved rollers 11 and 12, or a driven roller for either of the grooved rollers.

Further, an assist roller 13 is disposed between grooved rollers 11 and 12 of the main roller portion 10. The assist roller 13 is a rotatable cylinder smaller than grooved rollers 11 and 12 and located parallel to the grooved rollers so that its axis extends in the X-direction. Grooved rollers 11 and 12 and assist roller 13 have the same axial lengths and are arranged in parallel at the same position. The assist roller 13 is located opposite a space between the pair of workpieces W in the cutting area A1 such that a wire supporting position on its top surface is flush with those on grooved rollers 11 and 12. Thus, the cutting wire 2 can run on the assist roller 13 between grooved rollers 11 and 12. The assist roller 13 upwardly supports the cutting wire 2 between the two workpieces W that are arranged in parallel in the Y-direction, thereby preventing the wire from sagging between the grooved rollers.

Further, the outer peripheral surface of the assist roller 13 may be formed with grooves 13a, which extend circumferentially relative to roller 13 and are arranged at regular axial intervals at the same position as the grooves 11a and 12a. Alternatively, the outer peripheral surface of the assist roller 13 may be a smooth surface without grooves.

The workpiece feeding device 20 comprises a workpiece movement support section (material support section) 21. The support section 21 holds the workpieces W above the main roller portion 10 and moves in the Z-direction as indicated by the arrow in FIG. 2 under the control of the control section 60, thereby moving the workpieces W relative to the main roller portion 10. The two workpieces W are supported in parallel in the Y-direction on the support section 21 so that they can be simultaneously cut.

The delivery and take-up mechanisms 30A and 30B are constructed in the same manner. When one of mechanisms 30A and 30B serves as a delivery mechanism, the other serves as a take-up mechanism, and vice versa. In the present embodiment, for example, the one and the other mechanisms are assumed to be the delivery and take-up mechanisms 30A and 30B, respectively.

The delivery mechanism 30A comprises a delivery reel (bobbin) 31, guide rollers 32 to 34, dancer system 35, guide unit 36, rotational drive section 37, reel movement mechanism 38, and unit movement mechanism 39. The guide unit 36 supports rollers 32 to 34 and dancer system 35. The rotational drive section 37 is, for example, a motor that rotates the reel 31. The reel movement mechanism 38 axially reciprocates the reel 31. The unit movement mechanism 39 reciprocates the guide unit 36.

Likewise, the delivery mechanism 30B comprises a delivery reel (bobbin) 31, guide rollers 32 to 34, dancer system 35, guide unit 36, rotational drive section 37, reel movement mechanism 38, and unit movement mechanism 39. The guide unit 36 supports rollers 32 to 34 and dancer system 35. The rotational drive section 37 is, for example, a motor that rotates the reel 31. The reel movement mechanism 38 axially reciprocates the reel 31. The unit movement mechanism 39 reciprocates the guide unit 36.

Each reel 31 is in the form of a cylinder having flanges at its opposite ends and is located parallel to the main rollers 11 and 12 such that its axis extends in the X-direction. The cutting wire 2 is pitch-wound around the outer peripheral surface of the reel 31 between the end flanges in a reciprocating manner. The reel 31 is rotated at a predetermined speed by the rotational drive section 37.

The guide units 36 are located near their corresponding grooved rollers 11 and 12 and above the reels 31. The guide units 36 can be longitudinally reciprocated by the unit movement mechanism 39. The guide rollers 32 to 34 and dancer system 35 are pivotably supported on the front surface of each guide unit 36.

The guide rollers 32 to 34 are rotatably supported in predetermined positions on each guide unit 36. Each of the guide rollers 32 to 34 is a disk having a groove on its outer peripheral surface. The cutting wire 2 is successively wrapped around the respective peripheral grooves of the guide rollers 32 to 34.

The dancer system 35 is located in a predetermined position between the guide rollers 32 and 33. The dancer system 35 comprises a dancer arm 35a, one end of which is rotatably supported in a predetermined position on the guide unit 36, and a dancer roller 35b rotatably supported on the other end of the dancer arm 35a. The wire tension is adjusted based on the angle of the dancer arm 35a. The dancer roller 35b is a disk having a groove on its outer peripheral surface, and the cutting wire 2 is wrapped around the peripheral groove. Wire travel positions defined individually by the respective peripheral grooves of the guide rollers 32 to 34 and dancer roller 35b supported on the unit 36 are adjusted to be flush with respect to the X-direction.

In the present embodiment, axis C2 of the guide roller 32 is located above and outside axis C1 of the reel 31 with respect to the Y-direction, and axis C3 of the guide roller 33 above and inside axis C2. Further, axis C5 of the dancer roller 35b is rotatably supported below and inside axis C3 by the swingable dancer arm 35a. Axis C4 of the guide roller 34 is located above and inside axis C5 and adjacent to respective axes C11 and C12 of grooved rollers 11 and 12. Axes C1 to C5, C11 and C12 are all located in the same direction and parallel to one another in the X-direction. The direction of these axes is perpendicular to the running direction of the wire 2.

The rotational drive sections 37 on the delivery and take-up sides each comprise a rotary motor and serve to rotate the reel 31 in response to control by the control section 60, thereby running the wire 2.

The reel movement mechanisms 38 on the delivery and take-up sides each comprise a servomotor 38a, ball screw 38b, and linear-motion guide 38c and serve to axially reciprocate the reel 31 in response to control by the control section 60, thereby adjusting the X-direction position of the reel 31. Since the cutting wire 2 is wound around the reel 31 between its flanges in a reciprocating manner, positional control is performed based on the wire position such that delivery point P1 at which the wire 2 is delivered from the delivery reel 31 is always flush with supply point P2 at which the wire is introduced to grooved roller 11 on the delivery side. Also, positional control is performed such that pay-out point P3 at which the cutting wire 2 is paid out from grooved roller 12 on the take-up side is always flush with take-up point P4 at which the wire is taken up by the take-up reel 31.

The unit movement mechanisms 39 on the delivery and take-up sides each comprise a servomotor 39a, ball screw 39b, and linear-motion guide 39c and serve to axially reciprocate the guide unit 36 in response to, for example, manual control or control by the control section 60, thereby adjusting the respective positions of the guide rollers 32 to 34 and dancer roller 35b. Positional adjustment (or positional alignment) is performed such that the wire travel positions on the peripheral surfaces of the guide rollers 32 to 34 and dancer roller 35b supported on the unit 36 on the delivery side are flush with delivery and supply points P1 and P2 with respect to the X-direction. Also, positional adjustment is performed such that the wire travel positions on the peripheral surfaces of the guide rollers 32 to 34 and dancer roller 35b supported on the unit 36 on the take-up side are flush with pay-out and take-up points P3 and P4.

The travel routes of the cutting wire 2 are defined within the same plane perpendicular to the axial direction by the positional control of the reel movement mechanisms 38 and the positional adjustment of the unit movement mechanisms 39.

The take-up mechanism 30B is constructed in the same manner as the delivery mechanism 30A. In this embodiment, the delivery mechanism 30A is located on one Y-direction side, and the take-up mechanism 30B on the other side. These mechanisms 30A and 30B are arranged symmetrically with respect to the Y-direction on the opposite sides of the main roller portion 10. With respect to the X-direction, however, the take-up mechanism 30B is located behind the delivery mechanism 30A by a predetermined distance corresponding to the size of the cutting area A1.

The cutting wire 2 is delivered from the delivery reel 31 in the delivery mechanism 30A and wrapped around the dancer roller 35b via the guide rollers 32 to 34. Then, the wire 2 is passed through the guide roller 34 to the main roller portion 10 and wound around grooved roller 11.

In the main roller portion 10, the cutting wire 2 is successively wrapped around the respective peripheral grooves of the parallel grooved rollers 11 and 12 and tightly stretched at a fixed pitch as it runs. The wire 2 discharged from the main roller portion 10 is wrapped around the dancer roller 35b via the guide roller 34 in the take-up mechanism 30B. Then, the wire 2 is passed through grooved rollers 33 and 32 and taken up by the take-up reel 31.

The operation input section 50 is disposed in, for example, the wire-type cutting device 1 and comprises various input buttons and switches with which the operator inputs instructions and the like. The operation input section 50 is connected to the control section 60.

The control section 60 controls the operations of the individual parts of the cutting device, including the workpiece feeding device 20, rotational drive sections 37, reel movement mechanisms 38, and unit movement mechanisms 39, according to the input content of the operation input section 50 and preset contents.

The control section 60 drives the rotational drive sections 37 to feed (or run) the cutting wire 2 at a predetermined speed. In an example of the travel operation, the cutting wire 2 is run from the side of the take-up mechanism 30B toward the delivery mechanism 30A after it is run from mechanism 30A to mechanism 30B. In another example, the cutting wire 2 is run in a forward direction for a predetermined distance or time from the side of the delivery mechanism 30A toward the take-up mechanism 30B, and thereafter, reversed (or run in the opposite direction) for a suitable distance and run forward again.

The control section 60 drives the workpiece feeding device 20 up and down to feed the workpieces W toward the main roller portion 10. The workpieces W are cut as they are pressed against the running cutting wire 2.

Further, the control section 60 drives the reel movement mechanisms 38 and unit movement mechanisms 39 to adjust the positions of the reels 31 and guide units 36.

Positional adjustment is performed such that the cutting wire 2 runs within the same YZ-plane from delivery point P1 of the delivery reel 31 to supply point P2 in front of the one grooved roller 11 of the main roller portion 10 via the guide rollers 32 and 33, dancer system 35, and guide roller 34. At the same time, positional adjustment is performed such that the cutting wire 2 runs within the same plane from pay-out point P3 at the back of the other grooved roller 12 of the main roller portion 10 to take-up point P4 of the delivery reel 31 via the guide roller 34, dancer system 35, and guide rollers 33 and 32.

In this case, a wire travel route for delivery is defined in a YZ-plane that is flush with the front end of the cutting area A1 of the main roller portion 10, while a wire travel route on the take-up side is defined in another YZ-plane that is flush with the rear end of the cutting area A1. The front and rear ends of the cutting area A1 may be defined at the positions of any of the grooves 11a and 12a arranged in parallel on grooved rollers 11 and 12. In the present embodiment, they are defined at the positions of the front-end groove 11a and rear-end groove 12a, respectively.

The wire-type cutting device 1 constructed in this manner has the following effects. Since grooved rollers 11 and 12 in the main roller portion 10 and the take-up or delivery reel 31 are arranged parallel so that their respective axes extend in the same direction, the frequency of change of the running direction of the wire 2 can be reduced. Thus, the possibility of the cutting wire 2 being bent, rotated, or twisted can be reduced, so that wire breakage can be prevented.

In the configuration in which the axes of the take-up and delivery reels extend at right angles to those of the main rollers so that the running direction of the wire is bound to be changed, it is necessary to manually adjust the position of an inlet/outlet for the main rollers and the positions of the guide rollers. According to the present embodiment, however, the frequency of change of direction can be reduced, so that the configuration is simple and the positions can be automatically adjusted. Thus, working efficiency and productivity can be improved.

In the wire-type cutting device 1 according to the embodiment described above, the travel positions of the cutting wire 2 can always be defined on the same plane by controlling the positions of the reels 31 and guide units 36. Since rollers 32 to 35b supported on the units 36 are configured to move integrally with one another, moreover, the positional control is easy. Since the positional control of the reels 31 obviates the necessity of guide sheaves, furthermore, the device configuration can be simplified.

Since the travel routes of the cutting wire 2 are simple, moreover, the necessary number of guide rollers can be reduced, so that the configuration can be further simplified. Thus, the cost of maintenance and inspection and the amount of waste can be reduced, so that advantages can be obtained, including improved quality, reduced costs, and reduced environmental impact.

For example, the material of the wire, number of guide rollers, Z- and Y-direction layouts of the rollers, specific configurations of the movement mechanism and other parts, etc., are not limited to the above-described embodiment and may be embodied in various other forms.

In the embodiment described above, for example, the positions of the guide units 36 are automatically adjusted by the control section 60. Alternatively, however, positional alignment may be performed by driving a motor by manual operation of, for example, adjustment buttons. Also in this case, the wire travel positions can be defined by aligning the positions of the guide units 36 according to the wire positions on grooved rollers 11 and 12.

## Claims

1. A wire-type cutting device (1) **characterized by** comprising:
a main roller portion (10) comprising a main roller (11, 12) on which a cutting wire (2) is stretched; and
a reel (31) which delivers or takes up the wire (2),
the reel (31) and the main roller (11, 12) being disposed having the same axial direction and capable of being arranged so that the wire (2) between the reel (31) and the main roller (11, 12) is perpendicular to the axial direction.

2. The wire-type cutting device of claim 1, **characterized by** further comprising a reel movement mechanism (38) configured to move the reel (31) axially and a control section (60) configured to control the operation of the reel movement mechanism (38).

3. The wire-type cutting device of claim 1, **characterized by** further comprising a plurality of guide rollers (32-34) disposed between the reel (31) and the main roller (11, 12) in a travel route of the wire (2) and a guide unit (36) supporting the guide rollers (32-34), a dancer system (35) comprising a dancer arm (35a) swingably supported on the guide unit (36) and a dancer roller (35b) pivotably supported on the dancer arm (35a), and a unit movement mechanism (39) configured to move the guide unit (36) axially.

4. The wire-type cutting device of claim 2 or 3, **characterized in that** a pair of main rollers (11, 12) are disposed parallel to each other in the main roller portion (10), the plurality of guide rollers (32-34) are disposed between the reel (31) and the main rollers (11, 12) in a travel route of the wire (2), and the wire (2) is disposed so as to pass through the same position with respect to the axial direction in a section from the reel (31) on the delivery side to the main roller (11) on the delivery side and to pass through the same position with respect to the axial direction in a section from the main roller (12) on the take-up side to the reel (31) on the take-up side.

5. The wire-type cutting device of claim 3 or 4, **characterized by** further comprising a workpiece support section (21) located opposite the main roller portion (10) and configured to movably support a material to be cut, wherein the main roller (11, 12) is a cylindrical grooved roller formed with a groove (11a, 12a) on the outer peripheral surface thereof in which the wire is held, the cylindrical reel (31), the circular guide rollers (32-34), and the circular dancer roller (35b) on the delivery side are located on one side of the main roller portion (10), the cylindrical reel (31), the circular guide rollers (32-34), and the circular dancer roller (35b) on the take-up side are located on the other side of the main roller portion (10), the guide unit (36) supporting the guide rollers (32-34) and the dancer system (35) is located above the reel (31), the wire (2) is configured to be delivered from the reel (31) on the delivery side, wrapped around the guide rollers (32-34) on the delivery side, stretched in the main roller portion (10), passed through the guide rollers (32-34) on the delivery side, and taken up by the reel (31) on the take-up side, and the material to be cut is cut in the main roller portion (10) by running the wire (2).

6. The wire-type cutting device of any one of claims 1 to 4, **characterized in that** the pair of main rollers (11, 12) are disposed in the main roller portion (10), each of the main rollers (11, 12) is formed with a groove (11a, 12a) at a fixed pitch axially, the wire (2) is held in the respective grooves (11a, 12a) of the main rollers (11, 12), wound a plurality of times, stretched at a predetermined pitch, and axially arranged in a plurality of rows in a predetermined cutting area (A1), a travel route of the wire (2) from the reel (31) on the delivery side to the main roller (11) on the delivery side is defined within a plane perpendicular to the axial direction, and a travel route of the wire (2) from the main roller (11) on the take-up side to the reel (31) on the take-up side is defined within another plane perpendicular to the axial direction.
